# EUROPEAN PATENT SPECIFICATION

(11) **EP 1 006 663 B1**
(45) Date of publication and mention of the grant of the patent: **14.06.2006**
(21) Application number: 99850185.2
(22) Date of filing: 30.11.1999
(51) Int. Cl.: H03M 1/10, H03M 1/30

(54) **A diagnosis means for position encoder signal processing circuitry**
Diagnosemittel für Schaltungen zur Verarbeitung von Positionsgebersignalen
Moyens diagnostics pour les circuits de traitement de signaux d'un codeur de position

(30) Priority: 03.12.1998 SE 9804210
(43) Date of publication of application: 07.06.2000
(73) Proprietor: LEINE & LINDE AB, 645 21 Strängnäs (SE)
(72) Inventor: Söderroos, Sune, S-633547 Eskilstuna (SE)
(74) Representative: Herbjörnsen, Rut

(56) References cited:
- DE-A- 4 003 734
- US-A- 5 051 579
- US-A- 5 406 267
- US-A- 5 623 254
- US-A- 5 723 858
- "Sensing and Preventing Encoder Failure" OEM DESIGN, January 1983 (1983-01), pages 26-28, XP009012368 UK

## Description

### FIELD OF INVENTION

The present invention relates to an encoder having a load sensor. It also relates to a diagnosis device for detecting a malfunction of circuitry connected to the output of an encoder.

### BACKGROUND OF THE INVENTION

Optoelectrical state indicators include an encoding disc that has an optically readable pattern. The disc pattern is read by one or more detectors which each deliver an electric signal in relation to the amount of light that is received in the detector, so that movement of the encoding disc in relation to the detector will be indicated by changes in the electric signal.

The encoding disc includes a periodic pattern, such as a plurality of light and dark fields of mutually the same size, for instance. When the encoding disc is turned or rotated, the change between dark and light fields can be detected and a change in angle thus determined.

Optoelectrical encoders are often used in environments that are subjected to much vibration, and often in a heavily contaminated environment. The encoder may, for instance, be used to generate the real values of shaft rotation in a paper machine. For instance, the encoder may be hung on a rotating shaft in the paper machine. The encoding disc is caused to rotate as the shaft rotates, and the encoder casing and detector are firmly affixed to the casing of the paper machine.

U.S. Patent Specification 4,827,123 describes an encoder that includes a pair of light sources and a pair of light detectors disposed on opposite sides of an optical shuttered disc. The shutters are comprised of two phase-shifted light tranmissive and light blocking areas which result in a change in the output signals from the detectors in accordance with the Gray Code as the optical disc rotates. According to U.S. 4,827,123, there is defined four states that occur in a specified first sequence in one rotational direction, and a specific second sequence when the optical disc rotates in the opposite direction. A microprocessor analyses the generated state sequences and, when none of the predetermined sequences occurs, generates an alarm state indicating that a failure has occurred in one of the light emitters or light detectors or on the optical disc.

US patent specification 5,406,267 discloses a system for monitoring the operation of an encoder having a scale which is illuminated by a light source, in which the output from the light source is adjusted in response to a correction signal indicating the status of the encoder scale.

### SUMMARY OF THE INVENTION

The present invention addresses the problem of providing a method which will facilitate the maintenance of a machinery including movement-determining or position-determining encoders.

The invention also addresses the problem of providing a method which facilitates the maintenance of control systems that include movement or position determining encoders.

According to an embodiment of the invention these problems are addressed by an encoder device comprising an encoding means and a detector which are movable relative to one another, the detector being adapted to generate at least one pulse signal whose amplitude changes with relative positional changes; the encoder further comprising:
a load sensor having an input coupled to receive the at least one pulse signal, and an output for delivering an output pulse signal; wherein
the encoder device comprises means for indicating when the sensed load exceeds a threshold level.

In case of an external error, such as e.g. a short-circuit in a signal line connected to the output of the load sensor, the load indication means will provide an indication thereof. This provides service personnel with information to the effect that there is an error in the circuitry connected to the output of the encoder.

When using a conventional encoder for the purpose of obtaining positional data in a machinery service personnel sometimes have to exchange a perfectly well operating conventional encoder based on the suspicion that the cause of a malfunction in the machinery is due to the encoder. This is time consuming work for nothing when the malfunction actually is outside the encoder, and moreover it also unnecessarily costly since a new encoder is purchased and installed in vain. With the use of an encoder according the invention the service personnel is immediately informed that they should seek the cause of the malfunction in circuitry outside of the encoder.

According to another embodiment of the invention there is provided a diagnosis device for detecting a malfunction of circuitry connected to the output of an encoder delivering at least one pulse signal; the diagnosis device comprising:
a load sensor having an input coupled to receive the at least one pulse signal, and an output for delivering an output signal; wherein
the diagnosis device comprises means for indicating when the sensed load exceeds a threshold level.

This solution makes it possible to install a diagnosis device in an existing control system so as to obtain indications of the cause of malfunctions. In this manner it is possible to modify an existing machinery without having to exchange the conventional encoder which is already installed. The diagnosis device may also be used by the service personnel as a portable error detection device for locating the position of an error.

### BRIEF DESCRIPTION OF THE DRAWINGS

So that the invention will be more readily understood, the invention will now be described with reference to the accompanying drawings, in which
Figure 1 is a block schematic illustrating a first embodiment of an inventive encoder;
Figure 2 illustrates a pattern encoding means;
Figures 3A and 3B illustrate respectively signals that can be generated in the encoder according to Figure 1A when the encoding means of Figure 2 moves relative to corresponding detector means;
Figures 4A and 4B illustrate respectively pulse signals that can be generated in response to signals illustrated in Figures 3A and 3B;
Figure 5 is a block schematic illustrating one embodiment of a signal analyzer;
Figure 6 illustrates a count value generated by a counter included in the signal analyzer according to Figure 5;
Figure 7 is a block diagram of a machinery including a motor having a shaft, the speed or position of which is measured with an encoder.
Figure 8 shows an embodiment of a diagnosis device having a load sensor.
Figure 9 is a schematic representation of a load sensor and a device for indicating when a sensed load exceeds a threshold level.

### DESCRIPTION OF PREFERRED EMBODIMENTS

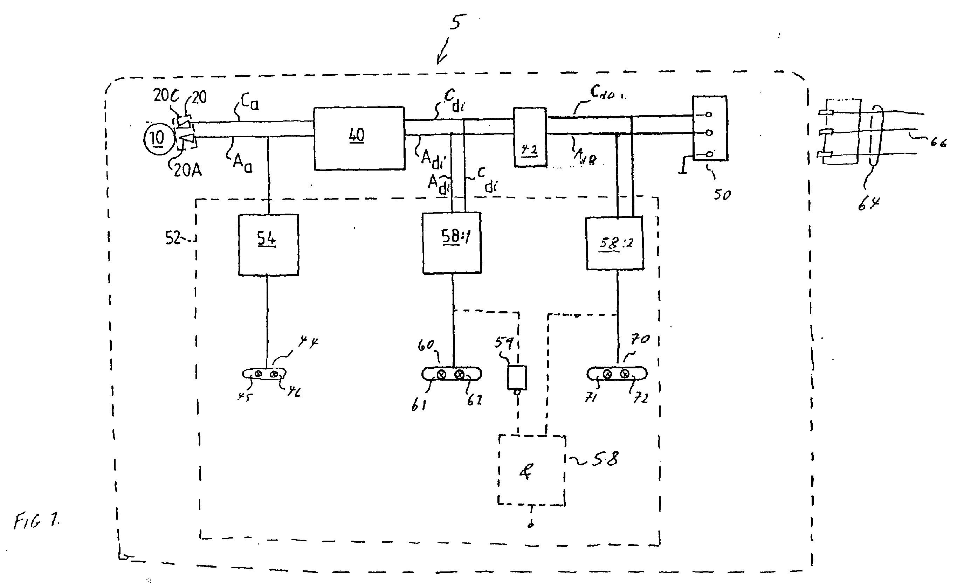

Fig. 1 is a block schematic illustrating an encoder unit 5 which includes an encoding disc 10 and a detector unit 20 for generating analogue electric signals whose amplitudes change in response to rotary movement of the encoding disc. The encoder unit also includes a pulse generator 40 for generating square-wave form signals on the basis of the analogue signals.

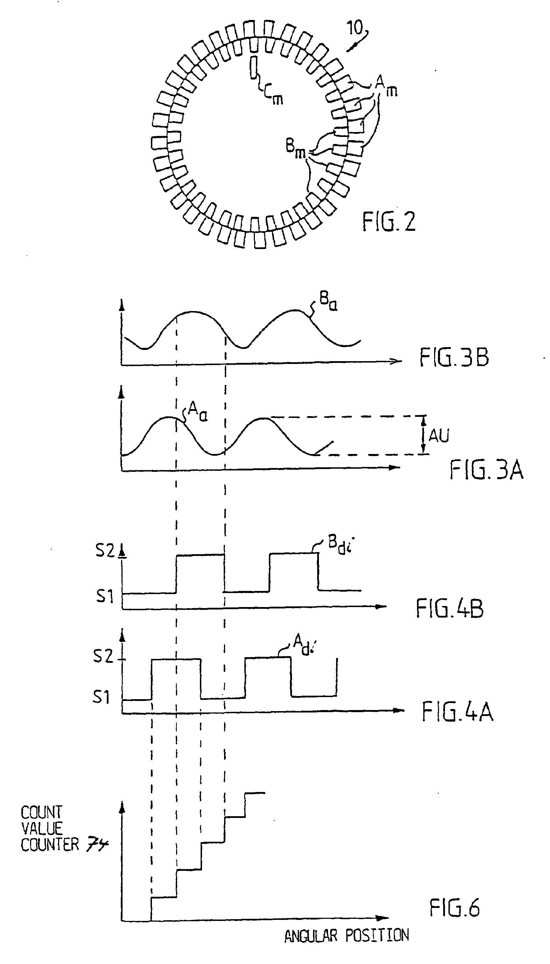

Fig. 2 illustrates a pattern on the encoding disc 10. The pattern includes three pattern groups Aₘ, Bₘ and Cₘ. As the pattern group Aₘ is moved in relation to a corresponding detector 20A, a sinusoidal-wave signal is generated, this signal being illustrated in Fig. 3A. Fig. 3B illustrates a sinusoidal signal that is displaced through 90° and that is generated when the pattern Bₘ is moved in relation to a corresponding detector 20B. The pattern Cₘ (see Fig. 2) causes the detector unit 20 to generate a reference pulse once with each revolution. The output signals from the detector unit are thus the signals Aₐ and Bₐ shown respectively in Figs. 3A and 3B, and a reference pulse is generated with each full revolution of the encoding disc 10. The pulse generator 40, which may include a Schmitt trigger for each input signal, generates the square-wave pulse trains A_{di} and B_{di} from respective sinusoidal signals Aₐ and Bₐ. The detector 20 includes detector elements 20A for generating signal Aₐ, 20C for generating signal Cₐ (see Fig 1) and 20B for generating signal Bₐ (not shown in Fig 1).

The quadrature signals A_{di} and B_{di} are delivered to a load sensor 42 for providing short-circuit protection of the output signals. The load sensor 42 delivers output signals A_{do}, B_{do}, and C_{d0} to a measurement signal output 50 of the encoder 5. The encoder 5 thus delivers on its measurement signal output 50 the two square-wave signals A_{do} and B_{do} and the reference signal C_{do}.

The encoder also includes a diagnostic unit 52. The diagnostic unit 52 includes a level analyzer 54 whose input is coupled so as to receive the signal Aₐ. Because a soiled or dirty encoding disc will result in poorer contrast and less distinct differences between light and dark parts of the encoding disc, the voltage swing of the electric signal generated by the detector when reading the encoding disc will also decrease as the encoding disc becomes dirtier. Thus the state of the encoding disc is monitored by means of the amplitude level of the analogue signal Aₐ, Bₐ or Cₐ.

Referring to Fig. 1, it will be seen that the diagnostic unit 52 includes a signal analyzer 58:1 whose input is coupled to the signal output of the comparator unit 40 for the square-wave signal A_{di}. The signal analyzer 58:1 operates to monitor the quadrature signal (or signals) so as to provide an indication if the output of the comparator unit 40 deviates from a predetermined pulse signal pattern. The provision of the signal analyzer 58:1, together with the level analyzer 54, makes it possible to discern a malfunction in the comparator device 40 from an impaired state of the encoder means 10 or the detector 20.

The diagnostic circuit 52 also includes an additional signal analyzer 58:2, which operates to monitor the quadrature signal A_{do} (or signals A_{do}, B_{do}, C_{do}) so as to provide an indication if the output of the load sensor 42 deviates from the predetermined pulse signal pattern. The provision of the signal analyzer 58:2, together with the signal analyzer 58:1, makes it possible to discern a malfunction in circuitry external to the encoder 5 from a malfunction in the internal circuitry of the encoder 5. The combination of the first signal analyzer 58:1, the load sensor 42 and the second signal analyzer 58:2 constitute an embodiment of a diagnosis device for detecting signal line errors on a signal line

The function of the diagnostic unit 52 is described in more detail below.

In a faultless encoder unit having a clean encoding disc the detector 20 will provide an analogue signal having a voltage swing ΔU with the value Uₘₐₓ (see Fig. 3A). Should the encoding disc become covered with a thin layer of dirt, the voltage swing between detector voltage in respect of a dark part and a light part will decrease. According to one embodiment of the invention, the encoder requires a voltage swing ΔU=5/10∗Uₘₐₓ in respect of the sinusoidal signal Aₐ in order for the comparator circuit 40 to generate the square-wave signal with sufficient reliability. According to this embodiment, the level analyzer 54 generates an error signal when the voltage ΔU is beneath the threshold value 5/10*Uₘₐₓ. The error signal is delivered to an indicator 44 having visual indicators. A green Light Emitting Diode (LED) 45 is lit when the voltage swing is higher than the threshold value ΔU=5/10∗Uₘₐₓ, and a red LED 46 is lit when the voltage swing is lower than the threshold value ΔU=5/10∗U_{max.} The red LED 46 being lit indicates an impaired state of the detector/encoding disc arrangement.

Referring to Fig. 1, it will be seen that the input of signal analyzer 58:1 is coupled to the signal output of the comparator unit 40 for the square-wave signal A_{dj}. The signal analyzer 58:1 is adapted to generate a second error signal when the square-wave signal deviates from a predetermined pulse signal pattern. According to one embodiment such a deviating pulse signal pattern is detected by counting the number of pulses or pulse edges of the square-wave signal A_{di} that occur in the interval between receiving two consecutively generated reference pulses C_{di}, and comparing the count value with a stored value corresponding to the number of pattern parts or the number of pattern boundaries on the encoding disc. The second error signal is delivered to an indicator 60 having a green LED 61 for indicating correspondence with the predetermined pulse signal pattern, and a red LED 62 providing visual indication when the error signal indicates that the square-wave signal deviates from the predetermined pulse signal pattern.

In the same manner the additional signal analyzer 58:2 generates a third error signal, which is delivered to an indicator 70 having a green LED 71 and a red LED 72. The red LED 72 is lit in response to the third error signal indicating a malfunction in circuitry external to the encoder 5. The indication of an external error may be obtained in the manner described below.

The load sensor 42 includes circuitry for protecting the components of the encoder 5 from damage e.g. in case of short-circuit on a signal line 64 connected to the output port 50. According to an embodiment the load sensor 42 has a circuit for increasing the resistance in the signal path (e.g. from input of A_{di} to output of A_{do} in the load sensor) in case of an increased current being drained from the output 50. According to one embodiment the load sensor 42 includes a resistor having a Positive Temperature Coefficient, i.e. a thermistor of the PTC-type. In this manner, the increased current drain resulting from a short-circuit in signal line 64 between the A_{do}-conductor 66 and signal ground leads to an increased current through the thermistor. The increased current leads to an increased resistive loss in the form of heat in the thermistor, which in turn leads to an increased resistance in the PTC-thermistor. In effect, the voltage amplitude of the quadrature signal A_{di} will be maintained substantially unaffected by any short-circuit of signal line 66, whereas the voltage amplitude of the quadrature signal A_{do} will be decreased significantly or completely in response to such a short-circuit.

Hence, in the case of a short-circuit of signal line 66 the additional signal analyzer 58:2 will sense that there are fewer pulses than there should be. In response to the detection of fewer pulses, or no pulses at all, the additional signal analyzer 58:2 sets the third error signal such that the red LED 72 indicates an error. In this manner the red LED 72 being lit, and the green LED 61 being lit at the same time, indicates that the encoder 5 functions properly but there is some error on the external line 64, or in some external circuit connected to the external line 64.

With reference to Fig. 1 there is shown an AND gate 58 having one input coupled to receive the second error signal (produced by the second signal analyzer 58:2) and having the other input coupled to receive the inverse of the first error signal. The inverse of the first error signal is produced by an inverter 59 having its input coupled to the output of the first signal analyzer 58:1. In this manner the output of the AND gate 58 will indicate when there is an external error, i.e. when 58:2 indicates an error (red LED) while 58:1 indicates an OK- status (green LED).

According to one embodiment the signal analyzer 58:1 and/or 58:2 operates to analyze the sequence of outputs from the quadrature signals A_{d} and B_{d}. It will be appreciated that when the encoding disc moves in a first direction the signal combination A_{d}B_{d} will follow a sequence 00; 01; 11; 10. When the encoding disc moves in the opposite direction the signal combination A_{d}B_{d} will follow the pattern sequence 10; 11; 01; 00. If neither of these pattern sequences is obtained there is a malfunction. A direction detector provides a directional signal in response to the signals A_{d} and B_{d}. As the encoding disc rotates, the resultant signal combination and the signal which first has a positive or a negative edge provides information as to the direction in which the disc rotates, as is well known to the person skilled in this art. This solution has the advantage of providing indication of a malfunction even when the encoding disc moves back and forth over only a part of a full revolution, i.e. when the C-pulse is not generated.

### Figure 5

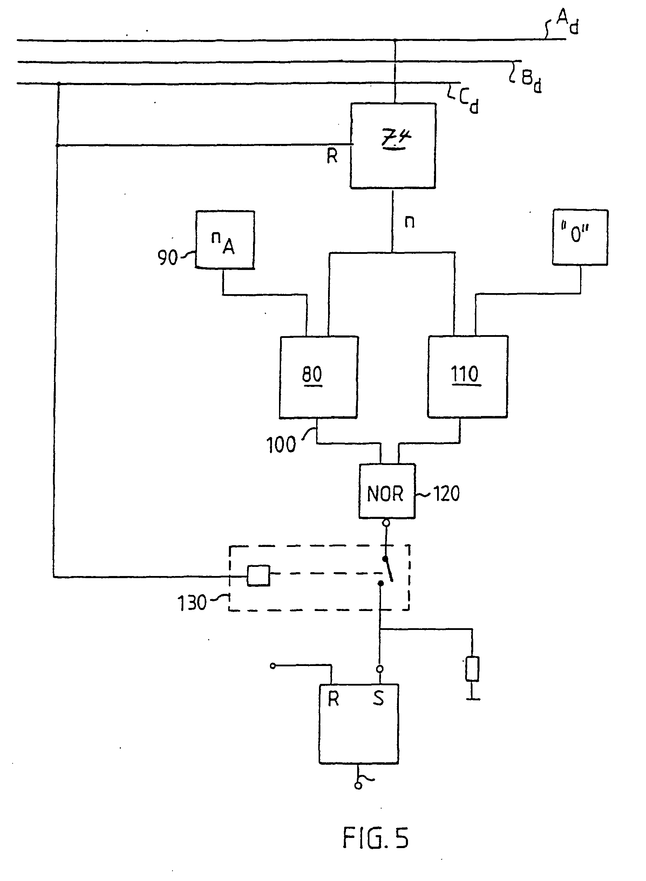

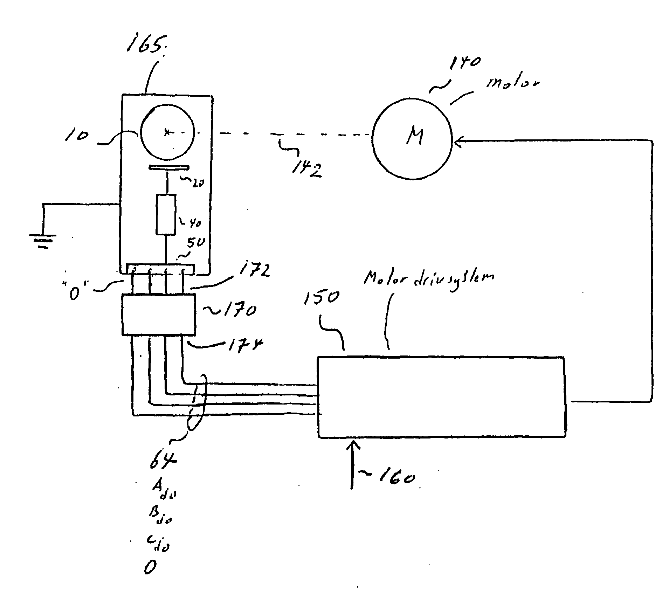

According to another embodiment, illustrated in Figure 5, the signal analyzer 58 includes a counter 74 which counts the number of pulses or pulse edges of the signal A_{d}. The counter delivers its count value to a comparing device 80, which compares the count value with a predetermined value n_{A}. This comparison is made upon receipt of the pulse C_{d}, whereafter the counter is zeroed. The function of the counter 74 is illustrated in Fig. 6. The counter 74 counts the number of pulse edges of the signals A_{d} and B_{d}, but is zeroed upon receipt of a reference pulse corresponding to the pattern Cₘ. The counter 74 is adapted to count-up in one direction of rotation and to count-down in the opposite direction of rotation. The direction of rotation is determined from the phase relationship between the signals A_{d} and B_{d}. The counter 74 thus counts the number of pulse edges during one revolution of the encoding disc, by counting the number of edges between two reference pulses C_{d}. This maximum count value is delivered to the comparing circuit 80. Also delivered to the comparing circuit 80 is a correct count value n_{A} that corresponds to the number of edges that shall be presented by the encoding disc during one revolution. When the encoder unit functions in the manner intended, the maximum count value from the counter 74 will thus correspond to the count value from the reference device 190. If the comparing circuit 80 detects that the two values do not agree, a fault indication signal is generated on its output 100.

When the direction of rotation is changed, the counter 74 will count down until zero ("0") is reached. When the encoder functions correctly, the value "0" will be obtained in conjunction with generating the reference pulse C_{d}. For this reason, the output signal n of the counter 74 is also delivered to a comparing circuit 110 that compares the count value with the value "0" (zero).

When the two input signals n and n_{A} (or n and "0") of the comparing circuit 80 (and 110) are in agreement, the comparing circuit generates a one ("1") on its output. A NOR circuit 120 receives the signals and generates a "0" when no fault exists.

The NOR circuit 120 generates a "1" (one) when none of the two comparing circuits indicates agreement.

Since the indicator signal is generated on the output of the NOR gate 120 precisely when receiving the reference pulse C_{d}, a valve 130 is arranged to couple the NOR gate 120 with an RS bistable multivibrator in response to the reference pulse.

The S-input of the RS bistable multivibrator is kept in a normally low state, although if the NOR gate delivers a "1" when the valve 130 is closed, the output signal of the RS bistable multivibrator will be set to "1".

The output of the RS bistable multivibrator delivers the third error signal.

According to a preferred embodiment the signal analyzer 58 includes circuitry for the above described counting analysis as well as circuitry for analysis of the signal sequence. This has the advantage of providing status reliable status indications both when the encoder is used for measuring fast rotations and when it is used for measuring movements over a small fraction of a revolution.

### Figure 7

Figure 7 is a block diagram of a machinery including a motor 140 having a shaft 142, the speed or position of which is controlled by a control system. The control system includes a motor drive system 150 which provides drive signals to the motor 140 dependent on a reference value received on a reference input 160 and the output of an encoder 165. The encoder 165 provides pulse signals A_{d}, B_{d}, C_{d}, via a signal line 64, in response to movement of the motor shaft 142. The pulse signals A_{di}, B_{di}, C_{di} and a signal ground "0" are provided on a multi-poled output of the encoder 165.

Quite often the signal line 64 has a significant length and it may run in an environment where there is a certain risk that the line is damaged. If the line is damaged such that the signal quality is adversely affected, the motor will be inadequately controlled. A common problem in this connection is that it is often suspected that the cause of the signal error is the encoder 165, wherefore the encoder is sometimes exchanged even though the actual malfunction is on the signal line 64 or in other circuitry connected to the encoder 165.

According to an embodiment of the invention there is provided a separate diagnosis device 170 for indicating whether the pulse signals are defective. In case there is a defective pulse signal the diagnosis device 170 operates to discern whether the error is to be found in the signal path before the diagnosis device 170 or after the diagnosis device 170.

The diagnosis device 170 has an input 172 connected to receive the pulse signals A_{di}, B_{di}, C_{di} and the ground signal "0" from the encoder 165. The diagnosis device 170 also has an output 174 for delivering the ground signal and the corresponding pulse signals A_{do}, B_{do}, C_{do}. A multi-conductor signal line 64 is provided for delivering the pulse signals A_{do}, B_{do}, C_{do} to the motor drive system 150.

The diagnosis device 170 comprises a load sensor 42 having an input coupled to receive the at least one of the pulse signals, e.g the signal A_{di}, and an output for delivering a corresponding output pulse signal A_{do}. The diagnosis device also comprises means for indicating when the sensed load exceeds a threshold level. According to an embodiment of the invention the diagnosis device 170 comprises signal analyzers 158:1 and 158:2 and indicators 60, 70 as described above with reference to Fig. 1.

### Figure 8

According to an embodiment of the diagnosis device 170, shown in Fig, 8, the load sensor comprises a thermistor 180. A comparator circuit is provided for comparing the signal states before and after the load sensor such that an indication is provided if the sensed load exceeds a threshold level.

According to one embodiment the comparator circuit comprises a EXLUSIVE OR-gate 182 (EXOR-gate) which is coupled such that one input of the EXOR-gate is connected to receive an input pulse signal A_{di} and another input of the EXOR-gate is connected to receive the signal provided after the thermistor 180. An indication device is coupled to the output of the EXOR-gate 182 so as to provide visual and/or acoustic indication when one EXOR-gate input goes LOW while the other input goes HIGH. The indication device comprises an External Error Indicator such as e.g. a red LED which is lit when the output of the EXOR-gate 182 goes HIGH.

The input port 172 and the output port 174 may be of a standardized type so as to enable easy plug-in of the diagnosis device 170 in an existing system such as the system shown in Fig. 7.

### The device operates as follows:

During normal operation the output signal A_{do} from the diagnosis device will have substantially the same voltage amplitude as that of the input signal A_{di}, since the input impedance of the circuitry connected to the output 174 is substantially higher than the impedance of the thermistor 180. Hence, the amplitude of the output signal A_{do} will change substantially in synchronisation with that of the input signal A_{di}. Hence, the output of the EXOR-gate will be LOW during normal operation.

When a malfunction occurs leading to a lower impedance of the circuitry connected to the output 174, there will be a voltage drop on the output side of the diagnosis device, since the relation is altered between the impedance of the thermistor 180 and the impedance of the circuitry connected to the output 174. The voltage difference is sensed by the EXOR-gate 182 and the output of the EXOR-gate 182 goes HIGH.

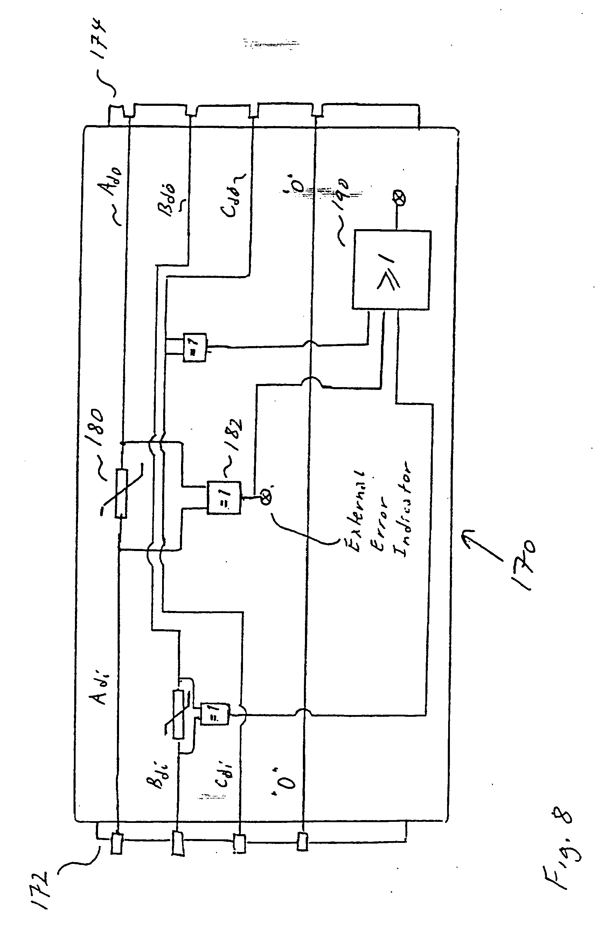

According to another embodiment there is provided an OR-gate 190 to the outputs of several EXOR-gates so as to obtain one error indication signal for all pulse signals, as shown in Fig. 8.

The circuitry for indicating when the sensed load exceeds a threshold level as described in connection with Fig. 8 may also be used in a diagnosis device 52 as described in connection with Fig. 1.

According to another embodiment of the invention the load sensor includes a current sensor, and the diagnosis device comprises an indicator for indicating when the sensed current exceeds a threshold level.

### Figure 9

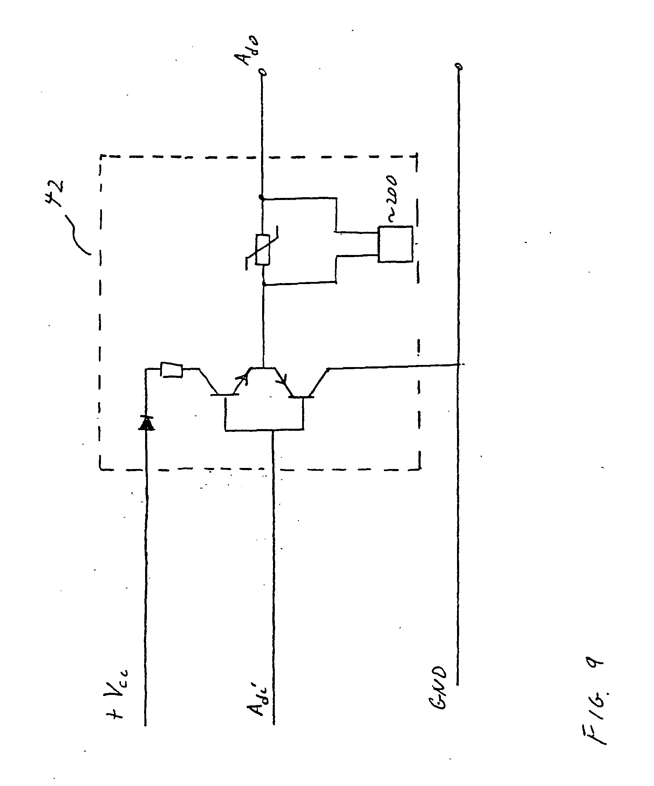

Figure 9 is a schematic representation of a load sensor 42 and a device 200 for indicating when the sensed load exceeds a threshold level. The device 200 may include signal analyzers 58:1 and 58:2, as described in connection with Figure 1 or 5 above. Alternatively it may comprise a logic circuitry as described in connection with Figure 8 above.

## Claims

1. A diagnostic device for detecting malfunction of circuitry of a load connected to an encoder device via the diagnostic device, the diagnostic device being arranged to receive at least one pulse signal (Ad.) generated by an encoder device (5, 165) having encoding means (10) and a detector (20, 40), wherein the amplitude of the pulse signal changes with relative position of the encoding means and the detector, **characterised by**
a load sensor (42; 180) for sensing the load; and
load indication means (200; 58:1, 58:2, 58 , 59; 58:1, 58:2, 61, 62, 71, 72; 182, 190) for generating an indication when the load exceeds a threshold level; wherein
the load sensor has an input (172) coupled to receive the at least one pulse signal, and an output (174) for delivering an output signal (A_{do}), the output being connectable to the load; and
the load indication means is arranged to receive the at least one pulse signal (A_{di}) and the output signal (A_{do}) and to generate the indication in response thereto.

2. The device according to claim 1, wherein
the load indication means includes a signal analyzer (58:2) coupled so as to detect when the output signal (A_{do}) deviates from a predetermined pulse signal pattern; and
the load indicating means is arranged to generate the indication in response to the detection.

3. The device according to claim 1, wherein
the load indication means includes a comparator (182) coupled to compare the at least one pulse signal (A_{di}) and the output signal (A_{do}); and
the load indicating means is arranged to generate the indication in response to the comparison.

4. The device according to any one of the above claims, wherein
the load indication means has means for providing visual or acoustic indication.

5. The device according to any one of the above claims, wherein
the load sensor is adapted to provide short-circuit protection of the output signals of the encoder device.

6. The device according to claim 5, wherein
the load sensor comprises a circuit for increasing the resistance in the signal path in response to an increased current being drained from the output.

7. The device according to claim6, wherein
the load sensor comprises a thermistor.

8. The device according to any one of the above claims, wherein
the load sensor comprises a current sensor.

9. An encoder device comprising an encoding means (10) and a detector (20,40) which are movable relative to one another, the detector (20,40) being adapted to generate the at least one pulse signal (A_{di}) whose amplitude changes with changes of the relative - position of the encoding means and the detector; the encoder device further comprising a diagnostic device according to any one of the preceding claims, wherein
the diagnostic device is coupled so as to receive the at least one pulse signal generated by the detector.

10. The encoder device according to claim 9, wherein
the detector includes means (20) for generating at least one analogue signal (Aₐ, Bₐ) whose amplitude changes with the relative position, and a pulse generator (40) for generating the at least one pulse signal (A_{di}) on the basis of said analogue signal (Aₐ);
the encoder device further comprises:
an amplitude analyzer (54) for generating a detection error signal on the basis of the amplitude of the analogue signal (Aₐ), and
a signal analyzer (58:1) for generating a pulse error signal on the basis of said at least one pulse signal (A_{di}, B_{di}); wherein
the amplitude analyzer (54) and the signal analyzer are coupled such that a combination of the detection error signal and the pulse error signal discerns a malfunction in the pulse generator (40) from an impaired state of the encoding means or the means (20) for generating at least one analogue signal.

## Patentansprüche

1. Diagnosevorrichtung zum Erfassen einer Schaltungsanordnung-Fehlfunktion einer Last, die mit einer Codierervorrichtung über die Diagnosevorrichtung verbunden ist, wobei die Diagnosevorrichtung angeordnet ist, um mindestens ein Impulssignal (A_{di}) zu empfangen, das durch eine Codierervorrichtung (5,165) erzeugt wird, die ein Codiermittel (10) und einen Detektor (20,40) aufweist, wobei sich die Amplitude des Impulssignals mit der relativen Position des Codiermittels und des Detektors ändert, **gekennzeichnet durch**,
einen Lastsensor (42;180) zum Abfühlen der Last; und
ein Lastangabemittel (200;58:1,58:2,58,59;58:1,58:2,61,62,71,72;182,190) zum Erzeugen einer Angabe, wenn die Last einen Schwellenpegel überschreitet; wobei
der Lastsensor einen Eingang (172), der gekoppelt ist, um das mindestens eine Impulssignal zu empfangen, und einen Ausgang (174) zum Liefern eines Ausgangssignals (A_{do}) aufweist, wobei der Ausgang mit der Last verbunden werden kann; und
das Lastangabemittel angeordnet ist, um das mindestens eine Impulssignal (A_{di}) und das Ausgangssignal (A_{do}) zu empfangen und die Angabe als Reaktion darauf zu erzeugen.

2. Vorrichtung gemäß Anspruch 1, bei der
das Lasteingabemittel einen Signalanalysator (58:2) aufweist, der gekoppelt ist, um zu erfassen, wenn das Ausgangssignal (A_{do}) von einem vorbestimmten Impulssignalmuster abweicht; und
das Lastangabemittel angeordnet ist, um die Angabe als Reaktion auf die Erfassung zu erzeugen.

3. Vorrichtung gemäß Anspruch 1, bei der
das Lastangabemittel einen Komparator (182) umfasst, der gekoppelt ist, um das mindestens eine Impulssignal (A_{di}) und das Ausgangssignal (A_{do}) zu vergleichen; und
das Lastangabemittel angeordnet ist, um die Angabe als Reaktion auf den Vergleich zu erzeugen.

4. Vorrichtung gemäß einem der obigen Ansprüche, wobei
das Lastangabemittel ein Mittel zum Bereitstellen einer visuellen oder akustischen Angabe umfasst.

5. Vorrichtung gemäß einem der obigen Ansprüche, bei der
der Lastsensor angepasst ist, um einen Kurzschlussschutz der Ausgangssignale der Codierervorrichtung bereitzustellen.

6. Vorrichtung gemäß Anspruch 5, bei der
der Lastsensor eine Schaltung zum Erhöhen des Widerstands in dem Signalweg als Reaktion darauf umfasst, dass ein erhöhter Strom von dem Ausgang gezogen wird.

7. Vorrichtung gemäß Anspruch 6, bei der
der Lastsensor einen Thermistor umfasst.

8. Vorrichtung gemäß einem der obigen Ansprüche, bei der der Lastsensor einen Stromsensor umfasst.

9. Codierervorrichtung mit einem Codiermittel (10) und einem Detektor (20,40), die bezogen zueinander bewegbar sind,
wobei der Detektor (20,40) angepasst ist, um mindestens ein Impulssignal (A_{di}) zu erzeugen, dessen Amplitude sich mit Änderungen der relativen Position des Codiermittels und des Detektors ändert, wobei die Codierervorrichtung ferner eine Diagnosevorrichtung gemäß einem der vorhergehenden Ansprüche umfasst, wobei
die Diagnosevorrichtung gekoppelt ist, um das mindestens eine durch den Detektor erzeugte Impulssignal zu empfangen.

10. Codierervorrichtung gemäß Anspruch 9, bei der
der Detektor Mittel (20) zum Erzeugen mindestens eines Analogsignals (Aₐ, Bₐ), dessen Amplitude sich mit der relativen Position ändert, und einen Impulsgenerator (40) zum Erzeugen des mindestens einen Impulssignals (A_{di}) auf der Grundlage des Analogsignals (Aₐ) umfasst;
wobei die Codierervorrichtung ferner umfasst:
einen Amplitudenanalysator (54) zum Erzeugen eines Erfassungsfehlersignals auf der Grundlage der Amplitude des Analogsignals (Aₐ) , und
einen Signalanalysator (58:1) zum Erzeugen eines Impulsfehlersignals auf der Grundlage des mindestens einen Impulssignals (A_{di}, B_{di}); wobei
der Amplitudenanalysator (54) und der Signalanalysator gekoppelt sind, so dass eine Kombination des Erfassungsfehlersignals und des Impulsfehlersignals eine Fehlfunktion in dem Impulsgenerator (40) von einem beeinträchtigten Zustand des Codiermittels oder der Mittel (20) zum Erzeugen mindestens eines Analogsignals unterscheidet.

## Revendications

1. Dispositif de diagnostic, permettant de détecter un disfonctionnement des circuits d'une charge, reliée à un dispositif formant codeur par l'intermédiaire du dispositif de diagnostic, le dispositif de diagnostic étant agencé pour recevoir au moins un signal d'impulsion (A_{di}), émis par un dispositif formant codeur (5, 165), possédant un moyen de codage (10) et un détecteur (20, 40), dans lequel l'amplitude du signal d'impulsian change avec la position relative du moyen de codage et du détecteur, **caractérisé par**
un capteur de charge (42 ; 180), permettant de détecter la charge et
un moyen d'indication de charge (200 ; 58:1. 58:2, 58, 59 ; 58:2, 61, 62, 71, 72, 182, 190), permettant de produire une indication quand la charge dépasse une valeur de seuil, dans lequel
le capteur de charge possède une entrée (172), couplée pour recevoir le au moins un signal d'impulsion et une sortie (174), permettant de délivrer un signal de sortie (A_{do}), la sortie pouvant être reliée à la charge et
le moyen d'indication de charge est agencé pour recevoir le au moins un signal d'impulsion (A_{dj}) et le signal de sortie (A_{do}) et pour produire l'indication en réponse à ceux-ci.

2. Dispositif selon la revendication 1, dans lequel
le moyen d'indication de charge comporte un analyseur de signal (58:2), couplé de façon à détecter quand le signal de sortie (A_{do}) s'écarte d'un modèle de signal d'impulsion prédéterminé et
le moyen d'indication de charge est agencé pour produire l'indication en réponse à la détection.

3. Dispositif selon la revendication 1, dans lequel
le moyen d'indication de charge comporte un comparateur (182), couplé pour comparer le au moins un signal d'impulsion (A_{di}) et le signal de sortie (A_{do}) et
le moyen d'indication de charge est agencé pour produire l'indication en réponse à la comparaison.

4. Dispositif selon l'une quelconque des revendications ci-dessus, dans lequel
le moyen d'indication de charge possède un moyen permettant de fournir une indication visuelle ou acoustique.

5. Dispositif selon l'une quelconque des revendications ci-dessus, dans lequel
le capteur de charge est adapté pour fournir une protection contre les courts-circuits des signaux de sortie du dispositif formant codeur.

6. Dispositif selon la revendication 5, dans lequel
le capteur de charge comprend un circuit permettant d'augmenter la résistance dans le trajet du signal, en réponse à une augmentation du courant, drainé depuis la sortie.

7. Dispositif selon la revendication 6, dans lequel
le capteur de charge comprend un thermistor

8. Dispositif selon l'une quelconque des revendications ci-dessus, dans lequel
le capteur de charge comprend un détecteur de courant.

9. Dispositif formant codeur, comprenant un moyen de codage (10) et un détecteur (20, 40), qui sont mobiles l'un par rapport à l'autre, le détecteur (20, 40) étant adapté pour émettre le au moins un signal d'impulsion (A_{di}), dont l'amplitude change avec les changements de la position relative du moyen de codage et du détecteur ; le dispositif formant codeur comprenant en outre un dispositif de diagnostic selon l'une quelconque des revendications précédentes, dans lequel
le dispositif de diagnostic est couplé de façon à recevoir le au moins un signal d'impulsion, émis par le détecteur.

10. Dispositif formant codeur selon la revendication 9, dans lequel
le détecteur comporte un moyen (20), permettant d'émettre le au moins un signal analogique (Aₐ, Bₐ), dont l'amplitude change avec la position relative et un générateur d'impulsion (40), permettant d'émettre le au moins un signal d'impulsion (A_{di}), sur la base dudit signal analogique (Aₐ) ;
le dispositif formant codeur comprend en outre:
un analyseur d'impulsion (54), permettant d'émettre un signal d'erreur de détection, sur la base de l'amplitude du signal analogique (Aₐ) et
un analyseur de signal (58:1), permettant d'émettre un signal d'erreur d'impulsion, sur la base dudit au moins un signal d'impulsion (A_{di}, B_{di}), dans lequel
l'analyseur d'amplitude (54) et l'analyseur de signal sont couplés, de sorte qu'une combinaison du signal d'erreur de détection et du signal d'erreur d'impulsion distingue un disfonctionnement dans le générateur d'impulsion (40) à partir d'un état altéré du moyen de codage ou du moyen (20) permettant d'émettre au moins un signal analogique.
